# EUROPÄISCHE PATENTSCHRIFT

(11) **EP 1 540 717 B1**
(45) Veröffentlichungstag und Bekanntmachung des Hinweises auf die Patenterteilung: **25.02.2015**
(21) Anmeldenummer: 03783922.2
(22) Anmeldetag: 26.07.2003
(51) Int. Cl.: H01L 21/02, H01S 5/183, H01L 21/316, H01L 21/322, H01L 21/324, H01L 21/687, H01L 21/67

(54) **VERFAHREN ZUM OXIDIEREN EINER SCHICHT UND ZUGEHÖRIGE AUFNAHMEVORRICHTUNGEN FÜR EIN SUBSTRAT**
METHOD FOR OXIDATION OF A LAYER AND CORRESPONDING HOLDER DEVICES FOR A SUBSTRATE
PROCEDE POUR OXYDER UNE COUCHE ET DISPOSITIFS CORRESPONDANT POUR PRENDRE EN CHARGE UN SUBSTRAT

(30) Priorität: 30.07.2002 DE 10234694
(43) Veröffentlichungstag der Anmeldung: 15.06.2005
(73) Patentinhaber: Infineon Technologies AG, 85579 Neubiberg (DE)
(72) Erfinder: CHUNG, Hin-Yiu, 89160 Dornstadt (DE); GUTT, Thomas, 85662 Hohenbrunn (DE)
(74) Vertreter: Kindermann, Peter
(86) Internationale Anmeldenummer: PCT/DE2003/002523
(87) Internationale Veröffentlichungsnummer: WO 2004/015754

(56) Entgegenhaltungen:
- US-A- 5 313 044
- US-A- 5 385 866
- US-A- 5 581 571
- US-A- 5 635 409
- US-A- 5 872 889
- US-A1- 2001 018 259
- US-A1- 2002 026 900
- US-B1- 6 342 691

## Beschreibung

Die Erfindung betrifft ein Verfahren wie im Anspruch 1 beansprucht, bei dem ein Substrat bereitgestellt wird, das eine zu oxidierende Schicht trägt. Die zu oxidierende Schicht ist Teil eines Schichtstapels, der das Substrat oder eine Grundschicht an einer Grundfläche der zu oxidierenden Schicht und eine Nachbarschicht an der der Grundfläche abgewandten Fläche der zu oxidierenden Schicht enthält. Im Randbereich des Schichtstapels liegt die zu oxidierende Schicht frei.

Ein Anwendungsbeispiel für solche Schichtstapel sind die in vertikalen Halbleiterlasern enthaltenen Spiegelschichten. Die vertikalen Halbleiterlaser werden auch als VCSEL (Vertical Cavity Surface Emitting Laser) bezeichnet. Bei dieser Anwendung soll in der zu oxidierenden Schicht durch die Oxidation eine Aperturblende eingestellt werden, die insbesondere auch zur Vorgabe eines Stromflusses dient.

Zur Oxidation des Schichtstapels ist das den Schichtstapel tragende Substrat in einer Heizeinrichtung einzubringen. Das Substrat wird dann mit einem Oxidationsgas umspült und bspw. auf eine Prozesstemperatur zwischen 100°C (Grad Celsius) und 500°C erwärmt. Bei einer alternativen Verfahrensführung wird das Substrat erst bei der Prozesstemperatur (Oxidationstemperatur) mit einem Oxidationsgas umspült.

Unter dem Einfluss des Oxidationsgases wird die Oxidationsschicht bei der Prozesstemperatur von ihrem Rand her mit fortschreitender Oxidationszeit immer weiter in den Schichtstapel hinein oxidiert. Die Oxidationsweite ist maßgeblich von der Prozesstemperatur abhängig. Bereits kleine Abweichungen der Prozesstemperatur von einer Solltemperatur führen zu erheblichen Abweichungen der Oxidationsweite von einer vorgegebenen Soll-Oxidationsweite.

Aus der US 5,581,571 ist ein Ofenprozess zur Herstellung eines Kanten-Halbleiterlasers bekannt. Mit dem Ofenprozess wird eine AlGa-Schicht lateral oxidiert. Die US 6,342,691 B1, US 2002/0026900 A1, US 5,635,409, US 5,872,889 und US 5,313,044 betreffen RTP. Aus der US 5,693,578 ist die Ausbildung von dünnem Siliziumoxid durch ganzflächige Oxidation bekannt. Aus der US 2001/0018259 A1 ist ein Verfahren zur Herstellung eines leitenden Leitungsmusters bekannt.

Es ist Aufgabe der Erfindung, zum Oxidieren einer solchen Schicht ein einfaches Verfahren anzugeben, mit dem insbesondere eine Oxidationsweite erzielt wird, die einer vorgegebenen Oxidationsweite möglichst genau entspricht. Außerdem sollen zugehörige Aufnahmevorrichtungen für ein Substrat angegeben werden.

Die auf das Verfahren bezogene Aufgabe wird durch die im Patentanspruch 1 angegebenen Verfahrensschritte gelöst. Zusätzlich zu den eingangs genannten Verfahrensschritten wird beim Verfahren das Substrat vorzugsweise in einem Einzelsubstratprozess in der Heizeinrichtung prozessiert. Außerdem wird während der Prozessierung die Prozesstemperatur über die Temperatur an einer Aufnahmevorrichtung für das Substrat erfasst. Die Aufnahmevorrichtung enthält hauptsächlich ein Material mit einer großen Wärmeleitfähigkeit bei der Prozesstemperatur.

Die Erfindung geht von der Überlegung aus, dass insbesondere bei Prozesstemperaturen unter 500°C die thermische Kopplung zwischen einer Ofenwand und dem zu prozessierenden Substrat vergleichsweise schwach ist. Deshalb wird beim Verfahren die Prozesstemperatur nicht an der Ofenwand sondern über die Temperatur der Aufnahmevorrichtung erfasst. Durch das Prozessieren nur eines Substrats an Stelle einer Vielzahl von Substraten in einem Einzelsubstratprozess wird bei einer Weiterbildung außerdem erreicht, dass die thermische Masse in der Heizeinrichtung klein ist. Durch diese Maßnahme lässt sich die Prozesstemperatur sehr schnell und mit geringem Überschwingen einstellen.

Durch den Einsatz des Verfahrens lassen sich Oxidationsschichten mit einer hohen Qualität und einer genau vorgegebenen Oxidationsweite oxidieren. Die Prozessierung von Einzelsubstraten bleibt außerdem wirtschaftlich, weil aufgrund der starken Abhängigkeit der Oxidationsweite von der Prozesstemperatur die Oxidation innerhalb weniger Minuten beendet ist.

Durch den Einsatz einer Aufnahmevorrichtung lässt sich u.a. eine sehr homogene Temperaturverteilung am Substrat erzielen. Dies ist Vorraussetzung für eine genaue Temperaturerfassung und damit auch für eine sehr genaue Prozessführung.

Bei einer Weiterbildung des Verfahrens bewirken 10°C Abweichung der Prozesstemperatur von einer Soll-Prozesstemperatur eine Abweichung der Oxidationsweite um mehr als 5 %, um mehr als 10 % oder sogar um mehr als 20 % von der Soll-Oxidationsweite. Derartig temperaturabhängige Oxidationsprozesse treten insbesondere bei der Oxidation von Schichten auf, die Halbleitermaterialien enthalten, beispielsweise Galliumarsenid oder Silizium. Dabei ist die zu oxidierende Schicht beispielsweise mit einem Metall dotiert, vorzugsweise mit Aluminium.

Bei einer Ausgestaltung enthält das Substrat ebenfalls Galliumarsenid. Die zu oxidierende Schicht ist bei einer anderen Ausgestaltung zwischen zwei Galliumarsenid-Schichten angeordnet. Galliumarsenid ist ein Halbleitermaterial, das insbesondere bei optischen Halbleiterbauelementen verwendet wird, insbesondere bei Halbleiterlasern. Wird die Oxidation von Schichten in diesem Material beherrscht, lassen sich hochwertige optoelektronische Bauelemente fertigen.

Bei einer anderen Weiterbildung des Verfahrens ist die Wärmeleitfähigkeit der Aufnahmevorrichtung bei 20°C größer als 10 Wm⁻¹K⁻¹ (Watt pro Meter und pro Kelvin), vorzugsweise größer als 100 Wm⁻¹K⁻¹. Das bedeutet, dass die Wärmeleitfähigkeit der Aufnahmevorrichtung so gut ist, wie es auch bei Metallen der Fall ist. Die Aufnahmevorrichtung selbst muss aber nicht aus einem Metall hergestellt sein. So wird bei einer Ausgestaltung eine Aufnahmevorrichtung verwendet, die mehr als 90 % Graphit enthält und vorzugsweise aus gepresstem Graphit gefertigt ist. Graphit hat insbesondere parallel zu den Schichtebenen der Graphitschichten eine gute Wärmeleitfähigkeit. Das Austreten von kleinen Graphitteilchen während der Prozessierung wird bei einer nächsten Weiterbildung durch eine Beschichtung der Aufnahmevorrichtung verhindert. Zur Beschichtung ist insbesondere Graphit geeignet, das mit Hilfe eines CVD-Verfahrens (Chemical Vapor Deposition) abgeschieden worden ist.

Bei einer nächsten Weiterbildung ist die Aufheizzeit der Heizvorrichtung vom Beginn des Heizvorgangs zum Aufheizen des Substrats bis zum Erreichen der Prozesstemperatur am Substrat kleiner als fünf Minuten. Eine so kurze Aufheizzeit wird durch die geringe thermische Masse und durch das direkte Erfassen der Prozesstemperatur am Substrat bzw. an der Aufnahmevorrichtung ermöglicht. Die Prozesstemperatur liegt vorzugsweise zwischen 350°C und 450°C. Herrscht am Beginn des Heizvorgangs eine Temperatur kleiner als 50°C in der Heizvorrichtung, so bedeutet dies, dass die Temperatur in der Heizvorrichtung während der Aufheizzeit um mehr als 300°C steigt. Eingesetzt werden Heizvorrichtungen, mit denen Temperaturerhöhungen größer als 40°C und bis zu 50°C pro Sekunde möglich sind, wobei die Abweichung zu einem vorgegebenen Temperaturverlauf kleiner als 5°C (Grad Celsius) oder kleiner als 1°C ist.

Die Verweildauer des Substrats in der Heizeinrichtung ist bei einer Weiterbildung kleiner als fünfzehn Minuten, insbesondere kleiner als zehn Minuten. Damit qualifiziert sich das Verfahren als Kurzzeittemperaturverfahren, d.h. als sogenanntes RTP-Verfahren (Rapid Thermal Processing). Geeignete Heizeinrichtungen für solche Verfahren ermöglichen z.B.:
- die Aufheizung der Siliziumscheibe zwischen zwei geheizten Graphitplatten (Rapid Isothermal Annealing), oder
- die Aufheizung der Siliziumscheibe durch Hochleistungslampen, insbesondere Halogenlampen (Rapid Optical Annealing).

Bei einer nächsten Weiterbildung des Verfahrens wird beim Aufheizen des Substrats auf die Prozesstemperatur mindestens ein Vorheizschritt durchgeführt, bei dem die Temperatur in der Heizvorrichtung für mindestens zehn Sekunden oder mindestens dreißig Sekunden auf einer Vorheiztemperatur gehalten wird, die kleiner als die Prozesstemperatur und größer als eine Kondensationstemperatur des Oxidationsgases, z.B. des Wasserdampfes. Werden als Trägermedium Wassermoleküle eingesetzt, so liegt die Vorheiztemperatur beispielsweise bei 150°C. Durch das Vorheizen wird erreicht, dass das Oxidationsgas, insbesondere Wasser, von der Aufnahmevorrichtung nicht so stark oder nicht absorbiert wird. Eine solche Absorption hätte negative Einflüsse auf die Prozessführung. Das Oxidationsgas wird bei einer Weiterbildung bei atmosphärischem Druck in die Heizvorrichtung eingeleitet.

Bei einer nächsten Weiterbildung ist die Aufnahmevorrichtung durch einen Deckel bedeckt. Der Deckel liegt auf dem Rand der Aufnahmevorrichtung auf oder ist in einem vorgegebenen Abstand zum Rand angeordnet, so dass sich ein Spalt zwischen Deckel und Rand der Aufnahmevorrichtung bildet. Liegt der Deckel auf der Aufnahmevorrichtung auf, so kann das Oxidationsgas aufgrund der Rauhigkeit des Deckels und der Aufnahmevorrichtung dennoch bis zum Substrat vordringen.

Das Verwenden eines Deckels ermöglicht es, dem sogenannten "Pattern"-Effekt entgegenzuwirken, wonach an Stellen mit verschiedenen Materialien oder mit verschiedener Strukturierung des Substrats bei der Prozessierung mit einer Strahlungsheizanlage voneinander verschiedene Temperaturen auftreten.

Bei einer nächsten Weiterbildung enthält die Heizvorrichtung gerade Heizelemente. Das Substrat hat eine kreisförmige Grundfläche, wie sie z.B. eine kreisförmige Halbleiterscheibe hat. Die Aufnahmevorrichtung enthält in Umfangsrichtung des Substratsumfangs eine Aussparung, in die vorzugsweise auswechselbar ein Ring aus einem Material eingebracht wird, das sich vom Material der Aufnahmevorrichtung unterscheidet, z.B. aus Silizium, Siliziumkarbid, Quarz oder Galliumarsenid. Durch geeignete Wahl des Ringmaterials lässt sich eine gleichmäßige Temperaturverteilung bei der Prozessierung über die gesamte Substratfläche erreichen.

Diese Weiterbildung geht von der Überlegung aus, dass Heizlampen der Heizvorrichtung zwar einzeln steuerbar sind, sich aber eine radialsymmetrische Wärmeverteilung durch das gezielte Ansteuern von geraden Lampen nicht erreichen lässt. Erst durch das Verwenden des radialsymmetrischen Ringes lässt sich eine gleichmäßigere Wärmeverteilung erzielen. Durch das Einbringen des Ringes lässt sich die thermische Masse der Box in einer für die Prozessführung geeigneten Art und Weise verändern. Durch das Austauschen von Ringen ist eine Anpassung an verschiedene Substrate und an verschiedene Prozessbedingungen möglich. Bei einer Ausgestaltung gibt es mehrere Ringe verschiedener Stärke aus dem gleichen Material.

Bei einer anderen Weiterbildung des Verfahrens ist die Heizeinrichtung für Heizraten größer als 8°C pro Sekunde geeignet. Der Schichtstapel enthält eine Schicht, die den Rand des Stapels überragt, vorzugsweise eine Kontaktschicht zur Kontaktierung des herzustellenden Halbleiterbauelementes. Dennoch wird beim Aufheizen auf die Prozesstemperatur eine Heizrate kleiner als 6°C pro Sekunde oder kleiner als 3°C pro Sekunde verwendet. Durch diese Maßnahme wird erreicht, dass insbesondere bei einer über den Rand hinausragenden Schicht aus Gold ein Absenken der Goldschicht am Rand verhindert wird. Damit steht die gesamte Kontaktschicht weiterhin für die Kontaktierung eines elektrischen Kontaktes zur Verfügung. Wird bei einer anderen Vorgehensweise keine Kontaktschicht verwendet, die den Schichtstapel seitlich überragt, so werden höhere Aufheizraten als 8°C pro Sekunde verwendet.

Bei einer anderen Weiterbildung wird das Oxidieren vor dem Erreichen einer Soll-Oxidationsweite unterbrochen. Die Oxidationsweite wird erfasst und abhängig von der erfassten Oxidationsweite wird eine Nachoxidation ausgeführt. Durch diese Vorgehensweise lässt sich auf für die Oxidation kritische Parameter zurückschließen, z.B. den Metallgehalt der zu oxidierenden Schicht oder die tatsächliche Anfangsgröße der herzustellenden Blende. Diese Rückschlüsse oder bereits die erfassten _Werte lassen sich zur Anpassung der Prozesszeit für einen zweiten Oxidationsschritt zur weiteren Oxidation derselben Oxidschicht verwenden. Auf diese Art und Weise lässt sich die Oxidationsweite sehr genau einstellen, d.h. bis auf eine vorgegebene Zieltiefe.

Bei einer Weiterbildung des Verfahrens enthält das Oxidationsgas Sauerstoff nur in gebundener Form, vorzugsweise in H₂O-Molekülen gebunden. Der Anteil von Sauerstoffmolekülen O₂ während der Prozessierung wird kleiner als 1 % gehalten, vorzugsweise auch kleiner als 0,01 %bezogen auf die Molekülanzahl pro Volumen, weil ansonsten die Oxidation der zu oxidierenden Schicht in den Schichtstapel hinein gestoppt werden würde. Dies ist möglicherweise darauf zurückzuführen, dass der reine Sauerstoff am Rand der zu oxidierenden Schicht eine andere Oxidation bewirkt, die im Unterschied zu der Oxidation mit gebundenen Sauerstoff das Eindringen von Sauerstoff in die Oxidationsschicht verhindert.

Bei einer anderen Weiterbildung wird die Temperatur mit einem Pyrometer oder mit mindestens einem Thermoelement erfasst, auf welchem das Substrat oder die Aufnahmevorrichtung aufliegt. Die genannten Bauelemente sind für eine genaue Temperaturmessung gut geeignet.

Die Erfindung betrifft außerdem die Verwendung des Verfahrens zum Herstellen eines elektronischen Halbleiterbauelementes mit elektronischen Kontakten. Überraschenderweise hat sich gezeigt, dass bei der Prozessführung der Kontaktwiderstand kleiner als 5 mal 10⁻⁷ Ω/cm⁻² (Ohm pro Quadratzentimeter) oder sogar kleiner als 4 mal 10⁻⁶ Ω/cm⁻² ist. Damit liegt eine für das Halbleiterbauelement wesentliche elektronische Kenngröße deutlich unter dem bisher erreichten Wert von beispielsweise 6 bis 9 x 10⁻⁶ Ω/cm⁻². Die Kontaktwiderstände sind insbesondere bei integrierten vertikalen Lasereinheiten für kurze Schaltzeiten von großer Bedeutung, z.B. in Lasereinheiten mit Schaltzeiten größer als ein Gigabit pro Sekunde oder größer als 2,5 Gigabit pro Sekunde.

Die oben als Weiterbildungen bezeichneten Verfahren mit einem Vorheizschritt und das Verfahren mit einer Unterbrechung des Oxidierens vor dem Erreichen einer Soll-Oxidationsweite werden auch bei Prozessführungen eingesetzt, die sich von der Prozessführung unterscheiden, beispielsweise hinsichtlich der Prozesstemperatur, hinsichtlich des Erfassens der Prozesstemperatur und/oder hinsichtlich des Regelns der Temperatur des Substrats.

Ausführungsbeispiele der Erfindung werden an Hand der beiliegenden Zeichnungen erläutert. Darin zeigen:
- Figur 1: einen Querschnitt durch einen vertikalen Halbleiterlaser mit einer zu oxidierenden Aperturblende,
- Figur 2: eine Anlage zum Durchführen der Oxidation,
- Figur 3: den Aufbau einer Heizvorrichtuhg,
- Figur 4: einen Temperaturverlauf am Substrat ohne Durchführung eines Vorheizschrittes,
- Figur 5: einen Temperaturverlauf am Substrat mit Durchführung eines Vorheizschrittes, und
- Figur 6: Verfahrensschritte bei einem Verfahren mit unterbrochener Oxidation.

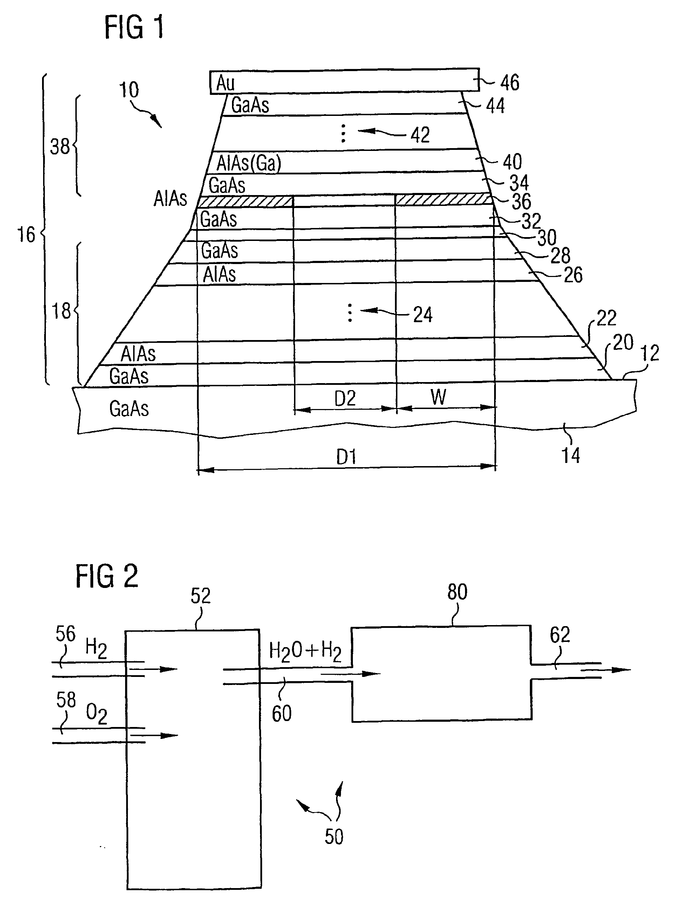

Figur 1 zeigt einen Querschnitt durch einen vertikalen Halbleiterlaser 10, bei dem ein Laserstrahl in Normalenrichtung einer Substratoberfläche 12 eines Halbleitersubstrats 14 austritt, das im Ausführungsbeispiel aus dem Verbindungshalbleiter Galliumarsenid besteht. Der Laserstrahl hat bspw. eine Wellenlänge von 890 Nanometern.

Der Halbleiterlaser 10 wird durch einen Schichtenstapel aus einer Vielzahl von Schichten gebildet, die im Folgenden näher erläutert werden. So gibt es in einer substratnahen Hälfte 18 des Schichtstapels 16 beginnend vom Substrat 14 die folgenden Schichten:
- eine unterste Galliumarsenidschicht 20,
- eine unterste Aluminiumarsenidschicht 22,
- eine durch Punkte dargestellte Schichtenfolge 24, die abwechselnd eine Galliumarsenidschicht, eine Aluminiumarsenidschicht, eine Galliumarsenidschicht usw. enthält,
- eine oberste Aluminiumarsenidschicht der substratnahen Hälfte 18, und
- eine oberste Galliumarsenidschicht 28 der substratnahen Hälfte 18.

Die Schichten 20 bis 28 bilden aufgrund der unterschiedlichen Brechungszahlen von Galliumarsenidschichten und Aluminiumarsenidschichten sogenannte Bragg-Spiegel. Beispielsweise enthält die substratnahe Hälfte 18 zehn Bragg-Spiegel.

In der Mitte des Schichtenstapels 16 befindet sich mindestens ein sogenannter Quantenfilm 30 zwischen der Galliumarsenidschicht 28 und einer Galliumarsenidschicht 32. Die Galliumarsenidschicht 32 und eine weitere Galliumarsenidschicht 34 schließen eine Aperturschicht 36 ein, die ursprünglich aus einer mit Aluminium dotierten Arsenidschicht besteht. Im Verlauf einer an Hand der Figuren 2 bis 6 näher erläuterten Oxidation wird das in der Aperturschicht 36 enthaltene Aluminium oxidiert, so dass sich eine Aperturblende bildet, die einen äußeren Durchmesser D1 hat, der mit dem Durchmesser des Schichtenstapels 16 auf der Höhe der Aperturschicht 36 übereinstimmt. Der Innendurchmesser D2 der Aperturblende hängt von der Oxidationsweite W bzw. der Oxidationstiefe in seitlicher Richtung des Schichtenstapels 16 ab.

Die Galliumarsenidschicht 34 bildet die unterste Schicht einer substratfernen Hälfte 38 des Schichtenstapels 16. In der substratfernen Hälfte 38 liegt beginnend an der Galliumarsenidschicht 34 eine Aluminiumarsenidschicht 40,
- eine Schichtenfolge 42, in der abwechselnd eine Galliumarsenidschicht, eine Aluminiumarsenidschicht, eine Galliumarsenidschicht usw. liegt, und
- eine oberste Galliumarsenidschicht 44 der substratfernen Hälfte 38, die sich an die letzte Aluminiumarsenidschicht der Schichtenfolge 42 anschließt. Die Schichten der substratfernen Hälfte 38 bilden aufgrund ihrer verschiedenen Brechungszahlen ebenfalls sogenannte Bragg-Spiegel, z.B. zehn Spiegel.

Auf der Galliumarsenidschicht 44 befindet sich eine Kontaktschicht 46 aus Gold, deren Rand den Schichtenstapel 16 entlang des gesamten Umfangs des Schichtenstapels 16 überragt. Das Überstehen der Kontaktschicht 46 gewährleistet eine bessere Kontaktierung eines auf der Kontaktschicht 46 aufzubringenden Kontaktes.

Die Bragg-Spiegelstrukturen des Schichtenstapels 16 lassen sich beispielsweise mittels Molekularstrahlepitaxie (Molecular Beam Epitaxy) aus [100] orientierten Galliumarsenidwafern herstellen. Die Schichtdicke einer Galliumarsenidschicht bzw. einer Aluminiumarsenidschicht beträgt beispielsweise 141 nm (Nanometer). Im Ausführungsbeispiel beträgt der Durchmesser D1 35 µm (Mikrometer) und der Durchmesser D2 13 µm. Die Aperturschicht 36 hat vor der Oxidation beispielsweise eine Dicke von 30 nm.

Eine Oxidation der Aluminiumarsenidschichten der substratnahen Hälfte und der substratfernen Hälfte 38 lässt sich beispielsweise durch die Zugabe von Gallium in diesen Schichten verhindern. Jedoch lassen sich auch andere Maßnahmen treffen, um die Oxidation zu verhindern, z.B. Teilbelackungen.

Figur 2 zeigt eine Anlage 50, die zum Durchführen der Oxidation der Aperturschicht 36 dient. Die Anlage 50 enthält eine Brennereinheit 52 und eine Heizvorrichtung 80.

Die Brennereinheit 52 hat einen Einlass 56 zum Einlassen von Wasserstoff H₂ sowie einen Einlass 58 zum Einlassen von reinem Sauerstoff O₂. In der Brennereinheit 52 werden der Wasserstoff und der Sauerstoff in einem beheizten Brennerrohr verbrannt, wobei Wasserdampf entsteht. Selbstverständlich lässt sich der Wasserdampf auch auf andere Weise erzeugen, z.B. durch Verdampfen von Wasser.

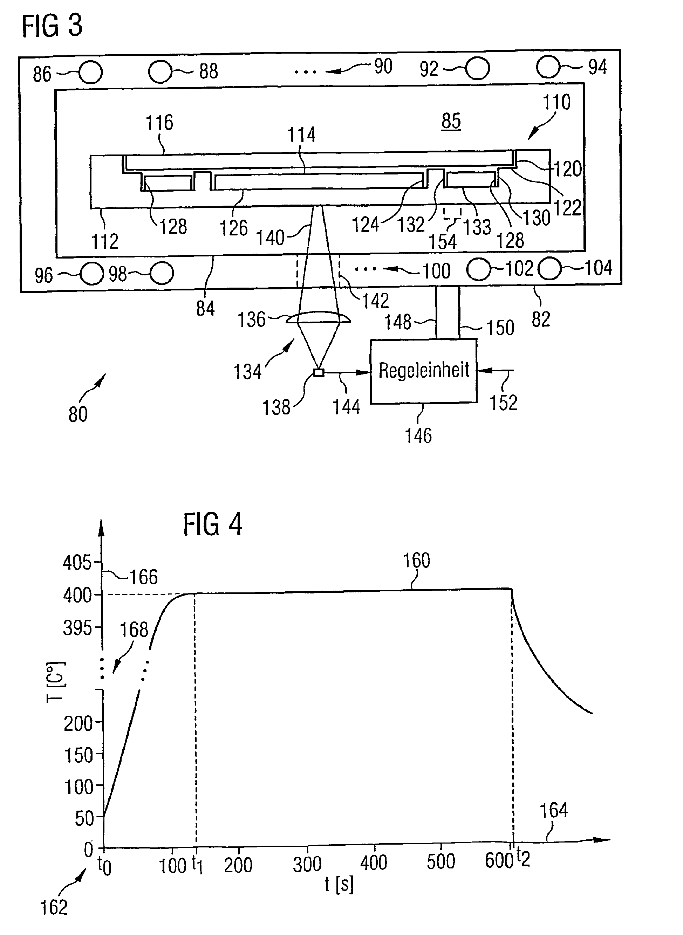

Der Wasserdampf und eine vorgegebene Menge Wasserstoff gelangen über ein Verbindungsrohr 60 aus der Brennereinheit 52 in die Heizvorrichtung 80, deren Aufbau unten an Hand der Figur 3 näher erläutert wird. Die Heizvorrichtung 80 hat einen Auslass 62, durch den die Reaktionsdämpfe aus der Heizvorrichtung 80 austreten können. Eine Reaktionsgleichung für die Oxidation in der Heizvorrichtung 80 lautet:

2AlAs + 3H₂O --> Al₂O₃ + 2AsH₃

Figur 3 zeigt den Aufbau einer Heizvorrichtung 80, die von einer quaderförmigen Reflektorwand 82 umgeben ist, die mit einem Material mit einer hohen Strahlungsreflexion an der innen liegenden Seite beschichtet ist. Innerhalb der Reflektorwand 82 befindet sich eine quaderförmige Heiz-Kammerwand 84 aus einem für die Wärmestrahlung von Halogenlampen gut durchlässigem Material, z.B. aus Quarzglas. Zwischen der Kammerwand 84 und der Reflektorwand 82 sind oberhalb einer Heizkammer 85 sowie unterhalb der Heizkammer 85 Halogenheizlampen 86 bis 104 angeordnet. Die Längsachsen der geraden Halogenheizlampen sind in Längsrichtung der quaderförmigen Heizvorrichtung 80 angeordnet.

Innerhalb der Kammerwand 84 befindet sich auf einer nicht dargestellten Haltevorrichtung eine scheibenförmige Graphitbox 110 mit einer kreisförmigen Grundfläche 112. Die Grundfläche ist bei einem anderen Ausführungsbeispiel quadratisch oder auch rechteckförmig. Die Graphitbox 110 dient zur Aufnahme einer Halbleiterscheibe 114, die beispielsweise das Halbleitersubstrat 14 enthält. Die Graphitbox 110 wird durch einen Graphitdeckel 116 verschlossen, wobei eine Diffusion des Oxidationsgases durch aufgrund der Materialrauheit vorhanden Zwischenräume zwischen der Graphitbox 110 und dem Graphitdeckel 116 möglich ist.

Die Graphitbox 110 enthält eine Aussparung zur Aufnahme des Graphitdeckels 116. Diese Aussparung wird in seitlicher Richtung durch eine Anschlagfläche 120 begrenzt, die entlang des Umfangs eines Kreises verläuft. Quer zur Anschlagfläche 120 liegt eine Auflagefläche 122, auf der der Graphitdeckel 116 aufliegt. Im Ausführungsbeispiel liegt die Anschlagfläche 120 im Winkel von 90° zur Grundfläche 112. Bei einem anderen Ausführungsbeispiel ist die Anschlagfläche 120 geneigt, um das Einlegen des Graphitdeckels 116 zu erleichtern.

Die Graphitbox 116 hat außerdem eine zentrale Aussparung zur Aufnahme der Halbleiterscheibe 114. Die zentrale Aussparung hat eine seitliche Anschlagfläche 124, die entlang des Umfangs eines Kreises liegt, gegebenenfalls ausgenommen ein Abschnitt der sich einem Flat der Halbleiterscheibe 114 anpasst. Im Ausführungsbeispiel liegt die Anschlagfläche 124 im rechten Winkel zur Grundfläche 112. Bei einem anderen Ausführungsbpispiel ist die Anschlagfläche 124 geneigt, um das Einlegen der Halbleiterscheibe 114 zu erleichtern.

Die zentrale Aussparung enthält außerdem eine ebene Auflagefläche 126, auf der die Unterseite der Halbleiterscheibe 114 großflächig aufliegt. Bei alternativ oder kumulativ ist der Abstand zwischen Auflagefläche und Unterseite kleiner als ein Millimeter oder kleiner als 0,5 Millimeter, z.B. 100 Mikrometer. Derartig kleine Spaltbreiten führen zu einer hohen Wärmekonvektion, die die gleiche Wirkung bezüglich der thermischen Kopplung wie eine hohe Wärmeleitfähigkeit hat.

Zwischen der zentralen Aussparung und der Auflagefläche 122 für den Graphitdeckel 116 liegt eine ringförmige Aussparung zur Aufnahme eines Einlageringes 128, der beispielsweise aus Silizium, Siliziumkarbid oder einem anderen geeigneten Material besteht.

Die ringförmige Aussparung hat eine äußere Anschlagfläche 130, die entlang des Umfangs eines Kreises verläuft und die im Ausführungsbeispiel senkrecht zur Grundfläche 112 liegt. Eine innere Anschlagfläche 132 der ringförmigen Aussparung liegt entlang des Umfangs eines konzentrischen Kreises mit einem kleineren Durchmesser als der Kreis, entlang dessen Umfang die äußere Anschlagfläche 130 liegt. Die innere Anschlagfläche 132 liegt ebenfalls im Winkel von 90° zur Grundfläche 112. Bei einem anderen Ausführungsbeispiel ist die äußere Anschlagfläche 130 nach außen und die innere Anschlagfläche 132 nach innen geneigt, um das Einlegen des Einlageringes 128 zu erleichtern. Am Boden der ringförmigen Aussparung befindet sich eine ebene Auflagefläche 133. Die Auflageflächen 122, 126 und 133 liegen parallel zur Grundfläche 112.

Die in Figur 3 dargestellte Graphitbox 110 hat einen ringförmigen Vorsprung zwischen der zentralen Aussparung und der ringförmigen Aussparung. Der Vorsprung wird seitlich durch die Anschlagfläche 124 und durch die innere Anschlagfläche 132 begrenzt. Bei einem anderen Ausführungsbeispiel hat die Graphitbox 110 keinen solchen Vorsprung, so dass die Halbleiterscheibe 14 und der Einlagering nur durch einen Spalt getrennt sind. Ein dem Einlagering 128 entsprechender Einlagering hat in diesem Fall einen inneren Radius, der nur geringfügig größer als der Außenradius der Halbleiterscheibe 114 ist, beispielsweise nur um einen oder zwei Millimeter.

Die in Figur 3 dargestellte Heizkammer 80 ist beispielsweise zur Prozessierung von Halbleiterscheiben 114 mit einem Durchmesser von vier Zoll (1 Zoll gleich 25,4 mm) geeignet. Jedoch gibt es auch Heizkammern 80 für Halbleiterscheiben mit einem größeren oder einem kleineren Durchmesser als vier Zoll.

Zum Erfassen der Temperatur T an der Grundfläche 112 der Graphitbox 110 und damit auch der Temperatur T der Halbleiterscheibe 114 wird bei einer ersten Variante ein Pyrometer 134 verwendet. Das Pyrometer 134 enthält ein Linsensystem 136 und dient zum Erfassen der von der Grundfläche 112 abgestrahlten Wärme über die Messung der Strahlungsintensität bei einer bestimmten Frequenz oder innerhalb eines bestimmten Frequenzbereiches mit Hilfe eines Strahlungssensors 138, z.B. eines Infrarot-Sensors. In Figur 3 ist außerdem der Strahlengang 140 des Pyrometers 134 dargestellt. Der Strahlengang 140 kreuzt ein für die Strahlung durchlässiges Fenster 142 in der Mitte des Bodens der Kammerwand 84 und der Reflektorwand 82. Bei anderen Ausführungsbeispielen wird das Pyrometer 134 anders angeordnet, beispielsweise auch innerhalb der Reflektorkammer 84 und/oder mit seitlichem Versatz zur Mittelachse der Halbleiterscheibe 114.

Vom Strahlungssensor 138 führen Leitungen 144 zu einer Regeleinheit 146 zum Regeln der Temperatur T in der Heizkammer 80. Die Regeleinheit 146 arbeitet beispielsweise mit Hilfe eines Mikroprozessors, der eine PID-Regelung (Proportional Integral Differenziell) ausführt. Aber auch Steuereinheiten werden eingesetzt. Von der Regeleinheit 146 führen Stromversorgungsleitungen 148, 150 zu den Halogenheizlampen 86 bis 104. Über die Vorgabe des Heizstroms lässt sich die Heizleistung der Halogenheizlampen 86 bis 104 steuern. Außerdem hat die Regeleinheit 146 eine durch einen Pfeil dargestellte Eingabemöglichkeit 152 zur Vorgabe eines Soll-Temperaturverlaufs. Der Temperaturverlauf ist beispielsweise durch die Vorgabe von Zeitpunkten und zugehörigen Temperaturen in einer Datei wählbar.

Bei einem anderen Ausführungsbeispiel wird an Stelle des Pyrometers 134 ein Thermoelement 154 verwendet, das an der Grundfläche 112 der Graphitbox 110 in der Mitte oder mit Versatz zur Mitte anliegt. Die Temperatur wird vorzugsweise in einem zentralen Bereich der Grundfläche 112 erfasst.

Figur 4 zeigt einen an der Grundfläche 112 erfassten Temperaturverlauf 160. Der Temperaturverlauf 160 ist in einem Koordinatensystem 162 dargestellt, das eine x-Achse 164 enthält, auf der die Zeit t in einem Bereich von Null Sekunden bis etwa 700 Sekunden dargestellt ist. Eine y-Achse 166 dient zur Darstellung der Temperatur T in einem Bereich von 0°C bis etwa 400°C. Die y-Achse 166 ist in einem mittleren Bereich 168 unterbrochen, um die Auflösung im oberen Temperaturbereich vergrößern zu können.

Das Halbleitersubstrat 14 wird in die Graphitbox 110 gelegt und in die Heizkammer 80 eingebracht. Bei einem anderen Ausführungsbeispiel wird das Substrat innerhalb der Heizkammer 80 in die Graphitbox eingebracht. Zu diesem Zeitpunkt hat die Graphitbox 110 beispielsweise eine Temperatur von etwa 50°C. Die Heizkammer wird anschließend mit Stickstoff gespült. Danach wird das Oxidationsgas in die Heizkammer 80 eingeleitet.

In einer Aufheizphase zwischen einem Zeitpunkt t0 und einem Zeitpunkt t1 bei etwa 130 Sekunden wird dann die Graphitbox 110 und damit auch das Halbleitersubstrat 12 auf eine Temperatur von 400°C erhitzt. Aufgrund der Temperaturerfassung an der Grundfläche 112 und der Wahl geeigneter Regelkonstanten tritt kein nennenswertes Überschwingen des Temperaturverlaufs 160 über den Temperaturwert 400°C auf.

Bei etwa 390°C setzt die Oxidation der Aperturschicht 36 beginnend vom Rand zum Inneren des Schichtstapels 16 hin ein. Mit zunehmender Oxidationszeit steigt die Oxidationsweite W. Zu einem Zeitpunkt t2 bei etwa 600 Sekunden hat die Apertur einen Innendurchmesser D2, d.h. den Soll-Innendurchmesser. Die Halogenheizlampen 86 bis 104 werden ausgeschaltet, so dass sich die Graphitbox 110 schnell abkühlen kann. Bei einer Temperatur unter z.B. 350°C wird die Heizkammer 85 mit innertem Gas gespült, falls das Oxidationsgas molekularen Wasserstoff enthält.

Hat die Graphitbox 110 eine Temperatur von etwa 200°C erreicht, so wird sie aus der Heizkammer 80 ausgeschleust. Der gesamte Vorgang zur Prozessierung der Halbleiterscheibe 14 ist kürzer als fünfzehn Minuten. Bei einem anderen Ausführungsbeispiel für einen Halbleiterlaser ohne den Stapel überragender Kontaktkante ist die Aufheizrate mehr als doppelt so hoch, z.B. dreimal so hoch.

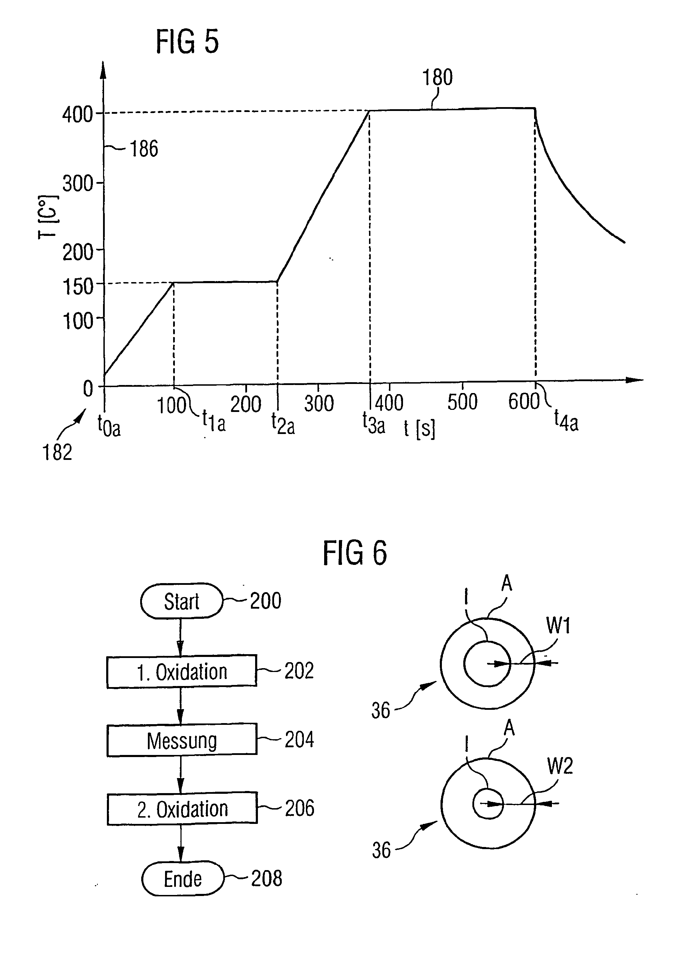

Figur 5 zeigt einen Temperaturverlauf 180 für eine Prozessierung bspw. eines eine hervorragende Kontaktkante tragenden Halbleitersubstrats 14 mit einem Vorheizschritt. Der Temperaturverlauf 180 ist in einem Koordinatensystem 182 dargestellt, das eine x-Achse 184 zur Darstellung der Prozesszeit t in einem Bereich von Null Sekunden bis etwa 700 Sekunden hat. Eine y-Achse 186 des Koordinatensystems 182 dient zur Darstellung der Temperatur T in der Heizkammer 80 in einem Temperaturbereich von 0°C bis 400°C.

Die Graphitbox 110 wird mit dem Halbleitersubstrat 14 in die Heizkammer 80 eingebracht. Anschließend wird mit Stickstoff oder einem anderen inerten Gas gespült. Danach wird Wasserdampf eingeleitet. Bei dem an Hand der Figur 5 erläuterten Ausführungsbeispiel hat die Graphitbox 110 zum Zeitpunkt t0 Zimmertemperatur von 20°C. Beginnend zum Zeitpunkt t0a bis zu einem Zeitpunkt t1a bei 100 Sekunden wird die Temperatur T in der Heizkammer 80 linear bis auf eine Vorheiztemperatur VT von 150°C erhöht. Für eine Zeit zwischen dem Zeitpunkt t1a und einem Zeitpunkt t2a bei etwa 250 Sekunden bleibt die Temperatur auf dem Wert 150°C.

Beginnend vom Zeitpunkt t2a bis zu einem Zeitpunkt t3a bei etwa 380 Sekunden steigt die Temperatur T während einer zweiten Aufheizphase in der Heizkammer z.B. linear vom Temperaturwert 150°C bis zum Temperaturwert 400°C an. Aufgrund der Anwesenheit des Oxidationsgases beginnt die Oxidation schon während der zweiten Aufheizphase.

Zwischen dem Zeitpunkt t3a und einem Zeitpunkt t4a bei etwa 600 Sekunden bleibt die Temperatur der Graphitbox 110 in der Heizkammer 80 und insbesondere an der Grundfläche 112 konstant auf dem Temperaturwert T von 400°C. In der Zeit zwischen den Zeitpunkten t3a und t4a wird die Aperturschicht 36 weiter oxidiert, bis die Oxidationsweite W erreicht ist.

Zum Zeitpunkt t4a werden die Halogenheizlampen 86 bis 104 ausgeschaltet, so dass sich die Heizkammer 80 wieder rasch abkühlt. Anschließend wird die Graphitbox 110 aus der Heizkammer 80 entnommen. Alternativ wird die Temperatur geregelt verringert.

Figur 6 zeigt Verfahrensschritte bei einem Verfahren mit unterbrochener Oxidation. Das Verfahren beginnt in einem Verfahrensschritt 200 mit dem Einbringen des Substrats 14 in die Heizkammer 80. In einem folgenden Verfahrensschritt 202 wird die Aperturschicht 36 bis zu einer Weite W1 oxidiert, die kleiner als die Oxidationsweite W ist. Die Oxidation wird beispielsweise gemäß dem an Hand der Figur 4 erläuterten Temperaturverlauf 160 durchgeführt. Jedoch wird nach einer Prozesszeit t = 350 Sekunden die Oxidation unterbrochen. Die Graphitbox 110 kühlt sich ab und wird dann aus der Heizkammer 80 entnommen.

Mit Hilfe einer Messvorrichtung wird die Aperturschicht 36 in einem Verfahrensschritt 204 vermessen, wobei die Oxidationsweite W1 zwischen einem Außenrand A und einem Innenrand I der Aperturblende in der Aperturschicht 36 ermittelt wird. Beispielsweise enthält die Messvorrichtung ein Infrarot-Mikroskop. Ausgehend von der gemessenen Weite W1 wird dann eine Nachoxidationszeit tr für die Restoxidation ermittelt.

In einem Verfahrensschritt 206 wird die teiloxidierte Aperturschicht 36 wieder in die Heizkammer 80 eingebracht und auf die Oxidationstemperatur von 400°C erhitzt, um für die berechnete Nachoxidationszeit tr eine Restoxidation durchzuführen. Nach Ablauf der Nachoxidationszeit tr wird die Oxidation beendet und die Halogenheizlampen 86 bis 104 werden ausgeschaltet.

Nach der Entnahme des Halbleitersubstrats 14 aus der Graphitbox 110 ist das Verfahren in einem Verfahrensschritt 208 beendet. Die Aperturblende in der Aperturschicht 36 hat nun einen Innenrand I, dessen Durchmesser dem Durchmesser D2 entspricht. Eine Oxidationsweite W2 zwischen dem Außenrand A und dem Innenrand I entspricht der Soll-Oxidationsweite W.

Bei einem anderen Ausführungsbeispiel wird das an Hand der Figur 6 erläuterte Verfahren mit dem an Hand der Figur 5 erläuterten Temperaturverlauf im Verfahrensschritt 202 und/oder Verfahrensschritt 206 ausgeführt.

Die Nachoxidationsmöglichkeit basiert darauf, dass die Oxidationskante in der Aperturschicht 36 bei der Entnahme des Substrats aus der Heizkammer 80 im Verfahrensschritt 202 schon eine so "niedrige" Temperatur hat, dass die Aperturblende noch aus Hydroxiden besteht, die ohne große Probleme nachoxidiert werden können.

## Patentansprüche

1. Verfahren zum Oxidieren einer Schicht (36),
mit den folgenden Schritten:
Bereitstellen eines Substrats (14), das eine zu oxidierende Schicht (36) trägt,
wobei die zu oxidierende Schicht (36) Teil eines Schichtstapels (16) ist, der das Substrat (14) oder eine Grundschicht (32) an einer Grundfläche der zu oxidierenden Schicht (36) und eine Nachbarschicht (34) an der der Grundfläche abgewandten Fläche der zu oxidierenden Schicht (36) enthält,
und wobei die zu oxidierende Schicht (36) in einem Randbereich des Schichtstapels (16) freiliegt,
Einbringen des den Schichtstapel (16) tragenden Substrats (14) in eine RTP-Heizeinrichtung (80),
Heranführen eines Oxidationsgases an das Substrat (36), Erhitzen des Substrats (36) auf eine Prozesstemperatur,
wobei die zu oxidierende Schicht (36) unter dem Einfluss des Oxidationsgases bei der Prozesstemperatur von ihrem Rand her mit fortschreitender Oxidationszeit immer weiter in den Schichtstapel (16) hineinoxidiert wird,
Erfassen der Prozesstemperatur während der Prozessierung über die Temperatur einer das Substrat (14) aufnehmenden Aufnahmevorrichtung (110) oder am Substrat (14),
und Regeln oder Steuern (152) der Temperatur des Substrats (14) auf eine vorgegebene Solltemperatur oder einen vorgegebenen Solltemperaturverlauf während der Prozessierung,
wobei die Verweildauer des Substrats (14) in der Heizeinrichtung (80) kleiner als fünfzehn Minuten oder kleiner als zehn Minuten ist,
und wobei die zu oxidierende Schicht (36) Galliumarsenid enthält.

2. Verfahren nach Anspruch 1, **dadurch gekennzeichnet, dass** eine Hauptfläche des Substrats (14) parallel an einer Hauptfläche der Aufnahmevorrichtung (110) anliegt oder in einem Abstand kleiner als drei Millimeter oder kleiner als ein Millimeter oder kleiner als 0,5 Millimeter angeordnet wird,
und/oder dass 10°C Abweichung in der Prozesstemperatur eine Abweichung der Oxidationsweite (W) um mehr als 5 % oder um mehr als 10 % oder um mehr als 20 % von einer Soll-Oxidationsweite bewirkt,
und/oder dass die zu oxidierende Schicht (36) mit einem Metall dotiert ist, vorzugsweise mit Aluminium,
und/oder dass das Substrat (14) Galliumarsenid enthält,
und/oder dass die zu oxidierende Schicht (36) zwischen zwei während der Prozessierung nicht zu oxidierenden Schichten (32, 34) angeordnet ist, vorzugsweise zwischen zwei Galliumarsenid enthaltenden Schichten (32, 34)
und/oder dass die Prozesstemperatur zwischen 100°C und 500°C liegt
und/oder wobei die Oxidationsweite (W) maßgeblich von der Prozesstemperatur abhängt,
und/oder wobei das Substrat (14) in einem Einzelsubstratprozess in der Heizeinrichtung (80) prozessiert wird.

3. Verfahren nach Anspruch 1 oder 2, **dadurch gekennzeichnet, dass** die Wärmeleitfähigkeit der Aufnahmevorrichtung (110) bei 20 °C größer als 10 Wm⁻¹K⁻¹ ist, vorzugsweise größer als 100 wm⁻¹K⁻¹,
und/oder dass die Wärmeleitfähigkeit der Aufnahmevorrichtung bei Prozesstemperatur größer als die Wärmeleitfähigkeit des Substrates (14) bei Prozesstemperatur ist,
und/oder dass die Aufnahmevorrichtung (110) Graphit enthält, vorzugsweise beschichtetes Graphit.

4. Verfahren nach einem der vorhergehenden Ansprüche, **dadurch gekennzeichnet, dass** eine Aufheizzeit der Heizvorrichtung (80) vom Beginn (t0) des Heizvorgangs bis zum Erreichen der Prozesstemperatur kleiner als fünf Minuten ist, wobei die Prozesstemperatur vorzugsweise zwischen 350°C und 450°C liegt,
und wobei am Beginn (t0, t0a) des Heizvorgangs eine Temperatur kleiner als 50°C in der Heizeinrichtung (80) herrscht.

5. Verfahren nach einem der vorhergehenden Ansprüche, **dadurch gekennzeichnet, dass** beim Aufheizen des Substrats (14) auf die Prozesstemperatur mindestens ein Vorheizschritt (t1a) durchgeführt wird, bei dem die Temperatur in der Heizvorrichtung (80) für mindestens zehn Sekunden oder mindestens dreißig Sekunden auf einer Vorheiztemperatur gehalten wird, die kleiner als die Prozesstemperatur und größer als eine Kondensationstemperatur des Oxidationsgases oder eines dem Oxidationsgas beigemischten Gases ist,
und dass mit dem Einlassen des Oxidationsgases in die Heizeinrichtung (80) vor dem Erreichen der Vorheiztemperatur oder bei der Vorheiztemperatur begonnen wird.

6. Verfahren nach einem der vorhergehenden Ansprüche, **dadurch gekennzeichnet, dass** die Aufnahmevorrichtung (110) durch einen Deckel (116) bedeckt wird,
und/oder dass der ein Deckel (116) auf einem Rand (122) der Aufnahmevorrichtung (110) aufliegt oder in einem vorgegebenen Abstand zum Rand (122) gehalten wird.

7. Verfahren nach einem der vorhergehenden Ansprüche, **dadurch gekennzeichnet, dass** die Heizvorrichtung (80) gerade Heizelemente (86 bis 104) enthält,
dass das Substrat (14) eine kreisförmige Grundfläche hat, und dass die Aufnahmevorrichtung 8110) in Umfangsrichtung des Substrats (14) eine Aussparung (130) enthält, in die ein vorzugsweise auswechselbarer Ring (128) aus einem Material gelegt wird, das sich vorzugsweise vom Material der Aufnahmevorrichtung (110) unterscheidet.

8. Verfahren nach einem der vorhergehenden Ansprüche, **dadurch gekennzeichnet, dass** die Heizeinrichtung (80) für Heizraten größer als 8°C pro Sekunde geeignet ist, dass der Schichtstapel (16) eine Schicht (46) enthält, deren Rand den Stapel (16) überragt, vorzugsweise eine Kontaktierungsschicht, wobei die Kontaktierungsschicht vorzugsweise Gold enthält,
und dass das Aufheizen auf Prozesstemperatur mit einer Heizrate kleiner als 6°C pro Sekunde oder kleiner als 3°C pro Sekunde durchgeführt wird.

9. Verfahren nach einem der vorhergehenden Ansprüche, **dadurch gekennzeichnet , dass** das Oxidieren vor dem Erreichen einer Soll-Oxidationsweite (W) unterbrochen wird (202),
dass die Oxidationsweite (W1) erfasst wird,
und dass abhängig von der erfassten Oxidationsweite (W1) eine Nachoxidation der zu oxidierenden Schicht ausgeführt wird (206).

10. Verfahren nach einem der vorhergehenden Ansprüche, **dadurch gekennzeichnet, dass** das Oxidationsgas Sauerstoff in gebundener Form mit mindestens einem anderen Element enthält, vorzugsweise in H₂O-Molekülen gebunden,
und dass der Anteil von molekularem Sauerstoff während der Prozessierung kleiner als 1 % ist.

11. Verfahren nach einem der vorhergehenden Ansprüche, **dadurch gekennzeichnet, dass** die Temperatur mit einem Pyrometer (134) oder mit mindestens einem Thermoelement (154) erfasst wird.

12. Verwendung des Verfahrens nach einem der vorhergehenden Ansprüche zum Herstellen eines elektronischen Bauelementes (10) mit elektrischen Kontakten (46),
wobei der Kontaktwiderstand des Kontaktes (46) kleiner als 5 mal 10⁻⁶ Ω/cm⁻² oder kleiner als 4 mal 10⁻⁶ Ω/cm⁻² ist,
oder wobei der Kontaktwiderstand kleiner als der bei einem herkömmlichen Ofenprozess entstehende Kontaktwiderstand bei sonst gleichen Materialien ist,
und/oder zur Herstellung einer integrierten vertikalen Lasereinheit (10).

## Claims

1. Method for oxidizing a layer (36),
comprising the following steps:
providing a substrate (14), which bears a layer (36) which is to be oxidized,
the layer (36) which is to be oxidized being part of a layer stack (16) which includes the substrate (14) or a base layer (32) at a base surface of the layer (36) which is to be oxidized, and a neighboring layer (34) which adjoins that surface of the layer (36) to be oxidized which is remote from the base surface,
and the layer (36) which is to be oxidized being uncovered in an edge region of the layer stack (16),
introducing the substrate (14) which bears the layer stack (16) into an RTP heating device (80),
passing an oxidation gas onto the substrate (36),
heating the substrate (36) to a process temperature, the layer (36) which is to be oxidized, as the oxidation time continues, being oxidized ever further from its edge into the layer stack (16) under the influence of the oxidation gas at the process temperature,
recording the process temperature during the processing via the temperature of a holding device (110) which holds the substrate (14) or at the substrate (14),
and controlling (152) the temperature of the substrate (14) to a predetermined desired temperature or a predetermined desired temperature curve during the processing,
wherein the residence time of the substrate (14) in the heating device (80) is less than fifteen minutes or less than 10 minutes,
and wherein the layer (36) which is to be oxidized contains gallium arsenide.

2. Method according to Claim 1, **characterized in that** a main surface of the substrate (14) bears parallel against a main surface of the holding device (110) or is arranged at a distance of less than three millimeters or less than one millimeter or less than 0.5 millimeter,
and/or **in that** 10°C deviation in the process temperature causes the oxidation width (W) to deviate by more than 5% or by more than 10% or by more than 20% from a desired oxidation width,
and/or **in that** the layer (36) which is to be oxidized is doped with a metal, preferably with aluminum,
and/or **in that** the substrate (14) contains gallium arsenide,
and/or **in that** the layer (36) which is to be oxidized is arranged between two layers (32, 34) which are not to be oxidized during the processing, preferably between two layers (32, 34) which contain gallium arsenide,
and/or **in that** the process temperature is between 100°C and 500°C,
and/or in which the oxidation width (W) is decisively dependent on the process temperature,
and/or in which the substrate (14) is processed in a single-substrate process in the heating device (80).

3. Method according to Claim 1 or 2, **characterized in that** the thermal conductivity of the holding device (110) at 20°C is greater than 10 Wm⁻¹K⁻¹, preferably greater than 100 Wm⁻¹K⁻¹,
and/or **in that** the thermal conductivity of the holding device at the process temperature is greater than the thermal conductivity of the substrate (14) at the process temperature,
and/or **in that** the holding device (110) contains graphite, preferably coated graphite.

4. Method according to one of the preceding claims, **characterized in that** a heat-up time of the heating device (80) from the start (t0) of the heating operation until the process temperature is reached is less than five minutes,
the process temperature preferably being between 350°C and 450°C,
and a temperature of less than 50°C prevailing in the heating device (80) at the start (t0, t0a) of the heating operation.

5. Method according to one of the preceding claims, **characterized in that** during the heating of the substrate (14) to the process temperature at least one preheating step (t1a) is carried out, in which the temperature in the heating device (80) is held at a preheating temperature, which is lower than the process temperature and higher than a condensation temperature of the oxidation gas or a gas which has been admixed with the oxidation gas, for at least ten seconds or at least thirty seconds,
and **in that** the oxidation gas starts to be admitted to the heating device (80) before the preheating temperature is reached or at the preheating temperature.

6. Method according to one of the preceding claims, **characterized in that** the holding device (110) is covered by a cover (116),
and/or **in that** the/a cover (116) rests on an edge (122) of the holding device (110) or is held at a predetermined distance from the edge (122).

7. Method according to one of the preceding claims, **characterized in that** the heating device (80) includes straight heating elements (86 to 104),
**in that** the substrate (14) has a circular base surface, and **in that** the holding device (110), in the circumferential direction of the substrate (14), has a recess (130) into which a preferably exchangeable ring (128) made from a material which is preferably different than the material of the holding device (110) is placed.

8. Method according to one of the preceding claims, **characterized in that** the heating device (80) is suitable for heating rates of greater than 8°C per second,
**in that** the layer stack (16) includes a layer (46) whose edge projects beyond the stack (16), preferably a contact-making layer, the contact-making layer preferably containing gold,
and **in that** the heating-up to process temperature is carried out at a heating rate of less than 6°C per second or less than 3°C per second.

9. Method according to one of the preceding claims, **characterized in that** the oxidation is interrupted (202) before a desired oxidation width (W) is reached, **in that** the oxidation width (W1) is recorded,
and **in that** a post-oxidation of the layer which is to be oxidized is carried out (206) as a function of the recorded oxidation width (W1).

10. Method according to one of the preceding claims, **characterized in that** the oxidation gas contains oxygen in a form bonded to at least one other element, preferably bonded in H₂O molecules,
and **in that** the level of molecular oxygen during processing is less than 1%.

11. Method according to one of the preceding claims, **characterized in that** the temperature is recorded using a pyrometer (134) or using at least one thermocouple (154).

12. Use of the method according to one of the preceding claims for fabricating an electronic component (10) with electrical contacts (46),
the contact resistance of the contact (46) being less than 5 times 10⁻⁶ Ω/cm⁻² or less than 4 times 10⁻⁶ Ω/cm⁻²,
or the contact resistance being lower than the contact resistance which is produced in a conventional furnace process using otherwise identical materials,
and/or for producing an integrated vertical laser unit (10).

## Revendications

1. Procédé d'oxydation d'une couche (36),
comprenant les stades suivants :
on se procure un substrat (14), qui porte une couche (36) à oxyder,
la couche (36) à oxyder faisant partie d'un empilement (16) de couches, qui comporte le substrat (14) ou une couche (32) de base sur une surface de base de la couche (36) à oxyder et une couche (34) de voisinage sur la surface, éloignée de la surface de base, de la couche (36) à oxyder,
et dans lequel la couche (36) à oxyder est dénudée dans une partie de bord de l'empilement (16) de couches,
on introduit le substrat (14) portant l'empilement (16) de couches dans un dispositif (80) de chauffage RTP,
on fait passer un gaz oxydant sur le substrat (36),
on porte le substrat (36) à une température de processus,
la couche (36) à oxyder étant oxydée, à partir de son bord, de plus en plus au sein de l'empilement (16) de couches, au fur et à mesure que s'écoule le temps d'oxydation à la température du processus, sous l'influence du gaz oxydant,
on détecte la température du processus pendant le traitement par la température d'un dispositif (110) de réception recevant le substrat (14) ou sur le substrat (14),
et on règle ou on commande (152) la température du substrat (14) à une température de consigne donnée à l'avance ou à une courbe de température de consigne donnée à l'avance pendant le traitement,
la durée de séjour du substrat (14) dans le dispositif (80) de chauffage étant plus petite que quinze minutes ou plus petite que dix minutes,
et la couche (36) à oxyder contenant de l'arséniure de gallium.

2. Procédé suivant la revendication 1, **caractérisé en ce qu'**une surface principale du substrat (14) s'applique parallèlement à une surface principale du dispositif (110) de réception ou est disposée à une distance plus petite que trois millimètres ou petite que un millimètre ou plus petite que 0,5 millimètre,
et/ou **en ce que** un écart de 10°C de la température de processus provoque un écart de la largeur (W) d'oxydation de plus de 5% ou de plus de 10% ou de plus de 20% à une largeur d'oxydation de consigne,
et/ou **en ce que** la couche (36) à oxyder est dopée par un métal, de préférence par de l'aluminium,
et/ou **en ce que** le substrat (14) contient de l'arséniure de gallium,
et/ou **en ce que** la couche (36) à oxyder est disposée entre deux couches (32, 34) à ne pas oxyder pendant le traitement, de préférence entre deux couches (32, 34) contenant de l'arséniure de gallium,
et/ou **en ce que** la température de processus est comprise entre 100°C et 500°C,
et/ou dans lequel la largeur (W) d'oxydation dépend d'une manière déterminante de la température de processus,
et/ou dans lequel on traite le substrat (14) dans un processus à substrat unique dans le dispositif (80) de chauffage.

3. Procédé suivant la revendication 1 ou 2, **caractérisé en ce que** la conductibilité thermique du dispositif (110) de réception à 20 °C est plus grande que 10 Wm⁻¹K⁻¹, de préférence, plus grande que 100 Wm⁻¹K⁻¹,
et/ou la conductibilité thermique du dispositif de réception à la température de processus est plus grande que la conductibilité thermique du substrat (14) à la température de processus,
et/ou **en ce que** le dispositif (110) de réception contient du graphite, de préférence du graphite de revêtement.

4. Procédé suivant l'une des revendications précédentes, **caractérisé en ce qu'**un temps de montée en température du dispositif (80) de chauffage, du début (t0) de l'opération de chauffage jusqu'à ce que la température de processus soit atteinte, est plus petit que cinq minutes, la température de processus étant comprise de préférence entre 350°C et 450°C,
et dans lequel il règne, au début (t0, t0a) de l'opération de chauffage, une température plus basse que 50°C dans le dispositif (80) de chauffage.

5. Procédé suivant l'une des revendications précédentes, **caractérisé en ce que**, lorsque le substrat (14) est porté à la température de processus, on effectue au moins un stade (t1a) de chauffage préalable, dans lequel on maintient la température dans le dispositif (80) de chauffage pendant au moins dix secondes ou pendant au moins trente secondes à une température de chauffage préalable qui est plus basse que la température de processus et qui est plus haute qu'une température de condensation du gaz oxydant ou d'un gaz mélangé au gaz oxydant,
et **en ce que** l'on commence à introduire le gaz oxydant dans le dispositif (80) de chauffage avant d'atteindre la température de chauffage préalable ou à la température de chauffage préalable.

6. Procédé suivant l'une des revendications précédentes, **caractérisé en ce que** l'on recouvre le dispositif (110) de réception d'un couvercle (116),
et/ou **en ce que** le couvercle (116) s'applique sur un bord (122) du dispositif (110) de réception ou est maintenu à une distance donnée à l'avance du bord (122).

7. Procédé suivant l'une des revendications précédentes, **caractérisé en ce que** le dispositif (80) de chauffage comporte des éléments (86 à 104) de chauffage rectilignes,
**en ce que** le substrat (14) a une surface de base circulaire,
et **en ce que** le dispositif (80) de réception comporte, dans la direction du pourtour du substrat (14), un évidement (130), dans lequel est mis un anneau (128), pouvant être de préférence remplacé, en un matériau qui se distingue de préférence du matériau du dispositif (110) de réception.

8. Procédé suivant l'une des revendications précédentes, **caractérisé en ce que** le dispositif (80) de chauffage est approprié à des vitesses de chauffage plus grandes que 8°C à la seconde, **en ce que** l'empilement (16) de couches contient une couche (46), dont le bord dépasse de l'empilement (16), de préférence une couche de mise en contact, la couche de mise en contact contenant de préférence de l'or,
et **en ce que** la montée à la température de processus s'effectue à une vitesse de chauffage plus petite que 6°C à la seconde ou plus petite que 3°C à la seconde.

9. Procédé suivant l'une des revendications précédentes, **caractérisé en ce qu'**on interrompt (202) l'oxydation avant d'atteindre une largeur (W) d'oxydation de consigne,
**en ce que** l'on détecte la largeur (W1) d'oxydation,
et **en ce qu'**en fonction de la largeur (W1) d'oxydation détectée, on effectue (206) une post-oxydation de la couche à oxyder.

10. Procédé suivant l'une des revendications précédentes, **caractérisé en ce que** le gaz oxydant contient de l'oxygène sous forme liée à au moins un autre élément, de préférence lié en des molécules d'H₂O, et **en ce que** la proportion d'oxygène moléculaire pendant le traitement est inférieure à 1%.

11. Procédé suivant l'une des revendications précédentes, **caractérisé en ce qu'**on détecte la température par un pyromètre (134) ou par au moins un thermocouple (154).

12. Utilisation du procédé suivant l'une des revendications précédentes, pour la fabrication d'un composant (10) électronique ayant des contacts (46) électriques,
la résistance du contact (46) étant plus petite que 5 fois 10⁻⁶ Ω/cm⁻² ou plus petite que 4 fois 10⁻⁶ Ω/cm⁻²,
ou la résistance du contact étant plus petite que la résistance de contact se produisant dans un processus au four habituel pour sinon les mêmes matériaux,
et/ou pour la fabrication d'une unité (10) laser verticale intégrée.
